# EUROPEAN PATENT SPECIFICATION

(11) **EP 4 350 480 B1**
(45) Date of publication and mention of the grant of the patent: **29.04.2026**
(21) Application number: 23729006.9
(22) Date of filing: 09.06.2023
(51) Int. Cl.: G06F 1/324, G06F 1/3234, G06F 1/3206, G06F 1/26

(54) **ELECTRONIC DEVICE AND COMPUTER-READABLE STORAGE MEDIUM FOR SETTING THE FREQUENCIES OF EACH CIRCUIT CONTAINED IN A PROCESSOR**
ELEKTRONISCHE VORRICHTUNG UND COMPUTERLESBARES SPEICHERMEDIUM ZUR EINSTELLUNG DER FREQUENZEN JEDER IN EINEM PROZESSOR ENTHALTENEN SCHALTUNG
DISPOSITIF ÉLECTRONIQUE ET SUPPORT DE STOCKAGE LISIBLE PAR ORDINATEUR POUR RÉGLER LES FRÉQUENCES DE CHAQUE CIRCUIT CONTENU DANS UN PROCESSEUR

(30) Priority: 24.08.2022 KR 20220106470; 29.09.2022 KR 20220124786
(43) Date of publication of application: 10.04.2024
(73) Proprietor: Samsung Electronics Co., Ltd., Suwon-Si, Gyeonggi-do 16677 (KR)
(72) Inventor: KIM, Jinkyu, Suwon-si Gyeonggi-do 16677 (KR); YU, Hyeokseon, Suwon-si Gyeonggi-do 16677 (KR)
(74) Representative: Nederlandsch Octrooibureau
(86) International application number: PCT/KR2023/007917
(87) International publication number: WO 2024/043464

(56) References cited:
- GB-A- 2 472 051
- JP-A- 2013 200 668
- KR-A- 20140 080 252
- KR-A- 20150 022 593
- KR-A- 20200 085 145
- KR-A- 20240 028 261
- US-A1- 2008 005 607
- US-A1- 2017 277 460

## Description

### [Technical Field]

Various embodiments relate to an electronic device, a method, and a computer readable storage medium for adjusting frequencies of each circuit included in a processor of the electronic device.

### [Background Art]

Recently, the distribution of various types of portable electronic devices such as a smart phone, a tablet PC, a wireless earphone, and/or a smart watch has been expanding. Such the portable electronic device may include a processor (e.g., CPU). The electronic device may drive a plurality of circuits included in the processor based on various frequencies. The electronic device may detect malfunctions for each of the plurality of circuits by adjusting the frequencies by using at least one policy (or governor). Patent document US 2017/0277460 A1, published on 28 September 2017, discloses a method for reducing memory subsystem power. In an exemplary method, a system resource manager provides memory performance requirements for a plurality of memory clients to a double data rate (DDR) subsystem

### [Disclosure]

### [Technical Solution]

An electronic device according to claim 1 of the invention comprises a power management integrated circuit (PMIC), a memory, and a processor. The processor is configured to identify whether to obtain driving information based on frequency of the processor, in response to an input indicating booting up the processor. The processor is configured to change frequencies of each of a plurality of circuits in the processor by using a designated data set including information indicating a change of a frequency according to a period for controlling each of the plurality of circuits, based on the booting up, by controlling the PMIC, in a designated state for obtaining driving information based on frequency of the processor. The processor is configured to obtain the driving information on the plurality of circuits in the processor about the frequencies, based on hit rates indicating number of operations performed by the plurality of circuits for each of the changed frequencies.

A computer readable storage medium storing one or more programs according to claim 11 of the invention, wherein the one or more programs, when executed by a processor of an electronic device, is configured to identify whether to obtain driving information based on frequency of the processor, in response to an input indicating booting up the processor. When executed by the processor of the electronic device, the one or more programs is configured to change frequencies of each of a plurality of circuits in the processor by using a designated data set including information indicating a change of a frequency according to a period for controlling each of the plurality of circuits, based on the booting up, by controlling a power management integrated circuit (PMIC), in a designated state for obtaining driving information based on frequency of the processor, and. When executed by the processor of the electronic device, the one or more programs is configured to obtain the driving information on the plurality of circuits in the processor about the frequencies, based on hit rates indicating number of operations performed by the plurality of circuits for each of the changed frequencies.

### [Description of the Drawings]

FIG. 1 is an exemplary block diagram of an electronic device in a network environment according to an embodiment.
FIG. 2 illustrates an example of a block diagram of an electronic device according to an embodiment.
FIG. 3 illustrates an exemplary circuit diagram illustrating a plurality of power sources included in a PMIC connected to each of the circuits included in the processor according to an embodiment.
FIG. 4 illustrates an exemplary state in which the processor of an electronic device according to an embodiment adjusts the frequency of each circuit included in the processor by using at least one governor.
FIG. 5 illustrates an exemplary flowchart illustrating an operation in which an electronic device according to an embodiment obtains a hit rate based on receiving one input.
FIG. 6 illustrates an exemplary flowchart illustrating an operation in which an electronic device according to an embodiment detects a malfunction by using a governor.
FIG. 7 illustrates an exemplary flowchart illustrating an operation in which an electronic device according to an embodiment adjusts a hit rate by using a governor.
FIG. 8 illustrates exemplary states in which an electronic device according to an embodiment identifies a malfunction based on at least one application.

### [Mode for Invention]

Hereinafter, embodiments of the present document will be described with reference to the accompanying drawings.

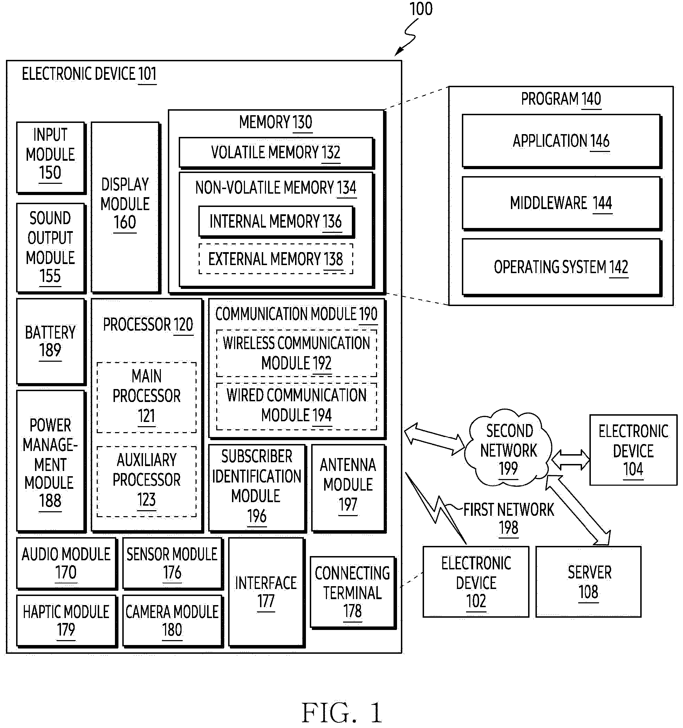

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments disclosed in the present document may be various types of devices. The electronic device may include, for example, a portable communication device (e.g., a smartphone), a computer device, a portable multimedia device, a portable medical device, a camera, a wearable device, or a home appliance. The electronic device according to an embodiment of the present document is not limited to the above-described devices.

With respect to the description of the drawings, similar reference numerals may be used for similar or related components. The singular form of the noun corresponding to the item may include one or more of the items unless clearly indicated differently in a related context. In this document, each of the phrases such as "A or B", "at least one of A and B", "at least one of A, B and C", "at least one of A, B, or C", and "at least one of A, B, or C" may include any one of the phrases together, or all possible combinations thereof. Terms such as "first", "second", or "second", or "second" may be used simply to distinguish a corresponding component from another corresponding component, and are not limited to other aspects (e.g., importance or order). When some (e.g., the first) component is referred to as "coupled" or "connected" in another (e.g., the second) component, with or without the term "functional" or "communicatively", it means that some of the components can be connected directly (e.g., wired), wirelessly, or through a third component.

The term "module" used in various embodiments of the present document may include a unit implemented in hardware, software, or firmware and be used interchangeably with terms such as logic, logic block, component, or circuitry, for example. The module may be a minimum unit or a part of the integrally configured component or the component that performs one or more functions. For example, according to an embodiment, the module may be implemented in the form of an application-specific integrated circuit (ASIC).

Various embodiments of the present document may be implemented as software (e.g., a program) including one or more instructions stored in a storage medium (or external memory) readable by a device (e.g., wearable device 100). For example, a processor (e.g., a processor) of a device (e.g., wearable device 100) may call and execute at least one of the one or more instructions stored from a storage medium. This makes it possible for the device to operate to perform at least one function according to at least one command called. The one or more instructions may include code generated by a compiler or code that may be executed by an interpreter. The device-readable storage medium may be provided in the form of a non-transitory storage medium. Here, the term 'non-transitory' only means that a storage medium is a device that is tangible and does not include a signal (e.g., electromagnetic wave), and the term does not distinguish between a case where data is semi-permanently stored and a case where it is temporarily stored.

According to an embodiment, a method according to various embodiments disclosed in the present document may be provided by being included in a computer program product. The computer program products may be traded between sellers and buyers as products. The computer program products may be distributed in the form of device-readable storage media (e.g., compact disc read only memory (CD-ROM), or distributed (e.g., downloaded or uploaded) directly or online through an application store (e.g., Play Store^{™}) or between two user devices (e.g., smartphones). In the case of online distribution, at least some of the computer program products may be temporarily stored or temporarily created on a device-readable storage medium such as a manufacturer's server, a server in an application store, or a memory in a relay server.

According to various embodiments, each of the above-described components (e.g., a module or a program) may include a single object or a plurality of obj ects, and some of the plurality of objects may be separated and disposed in other components. According to various embodiments, one or more components or operations of the above-described corresponding components may be omitted, or one or more other components or operations may be added. Alternatively, or additionally, a plurality of components (e.g., modules or programs) may be integrated into one component. In this case, the integrated component may perform one or more functions of each of the components in the same or similar manner as those performed by the corresponding component among the plurality of components before the integration. According to various embodiments, operations performed by a module, a program, or other components may be executed sequentially, in parallel, repeatedly, or heuristic, performed in a different order, omitted, or one or more other operations may be added.

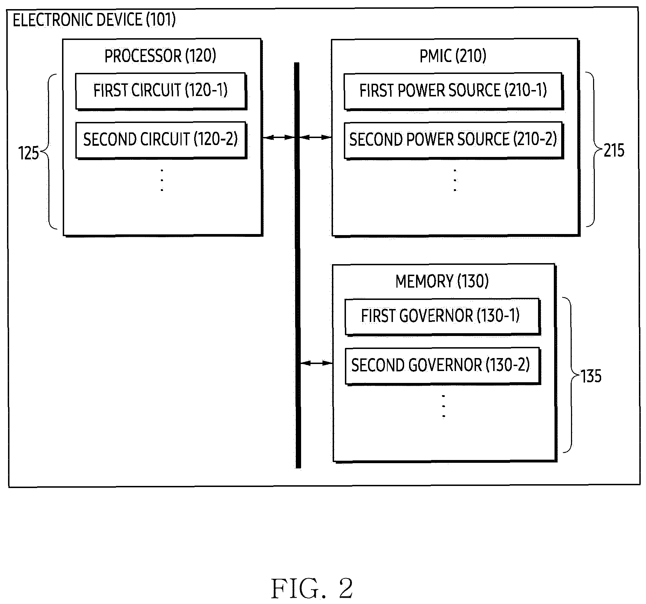

FIG. 2 illustrates an example of a block diagram of an electronic device according to an embodiment. Referring to FIG. 2, an electronic device 101 may be referred to the electronic device 101 of FIG. 1. A processor 120 may be referred to the processor 120 of FIG. 1. A memory 130 may be referred to the memory 130 of FIG. 1. A PMIC 210 may be included in a power management module 188 of FIG. 1.

Referring to FIG. 2, the electronic device 101 according to an embodiment may include at least one of the processor 120, the memory 130, and/or the PMIC 210. The processor 120, the memory 130, and the PMIC 210 may be electronically and/or operably coupled with each other by an electronical component such as a communication bus. The types and/or numbers of hardware components included in the electronic device 101 are not limited to those illustrated in FIG. 2. For example, the electronic device 101 may include only some of the hardware components illustrated in FIG. 2.

The processor 120 of the electronic device 101 according to an embodiment may include the hardware component for processing data based on one or more instructions. The hardware component for processing data may include, for example, an arithmetic and logic unit (ALU), a field programmable gate array (FPGA), an application processor (AP), a communication processor (CP), a neural processor circuit (NPC), a graphics processing unit (GPU), and a central processing unit (CPU). The number of processor 120 may be one or more. For example, the processor 120 may have a structure of a multi-core processor such as a dual core, a quad core, or a hexa core. The processor 120 may be an example of a system on chip (SoC) in that it includes a plurality of hardware components. For example, the processor 120 may further include a system memory, a flash memory, and/or a sensor.

The processor 120 according to an embodiment may include one or more circuits 125 (or domain). For example, the processor 120 may include volatile memory (SRAM) for processing at least one cache memory in at least some of the circuits 125. For example, the processor 120 may increase the speed for processing at least one piece of data by using the cache memory.

For example, a first circuit 120-1 and/or a second circuit 120-2 may correspond to one core among the multi-core included in the processor 120. For example, data that the processor 120 may process by using the first circuit 120-1 may include data that may be processed by using the second circuit 120-2. For example, the processor 120 may process a high-load task by using the first circuit 120-1. For example, the power used by the processor 120 to drive the first circuit 120-1 and the power used to drive the second circuit 120-2 may be different. For example, the frequency area set by the processor 120 to perform driving of the first circuit 120-1 may be different from the frequency area set to perform driving of the second circuit 120-2. For example, the frequency area set to drive the first circuit 120-1 may include or partly overlap the frequency area set to drive the second circuit 120-2.

The processor 120 according to an embodiment may perform at least one function by using at least some of the circuits 125. For example, at least some circuit among the circuits 125 may be referred to at least one of an image signal processor (ISP), a camera image sensor (CIS), and/or an internal memory (INT). For example, the processor 120 may include a circuit for transmitting data to memory (e.g., a memory controller), a circuit for processing image data (e.g., an image signal processor (ISP)), a communication circuit (e.g., a network interface) for establishing a communication link with an external electronic device, a circuit for processing video (e.g., an encoder), and/or a circuit related to display (e.g., a display controller). For example, the processor 120 may load data from the memory 130 by using the memory controller. For example, processor 120 may obtain data for processing an image obtained from the camera by using the ISP. For example, the processor 120 may use the display controller to obtain data to be displayed on the display of the electronic device 101. For example, by using the display controller, the processor 120 may obtain data that may be displayed on the display from the image data obtained by using the ISP.

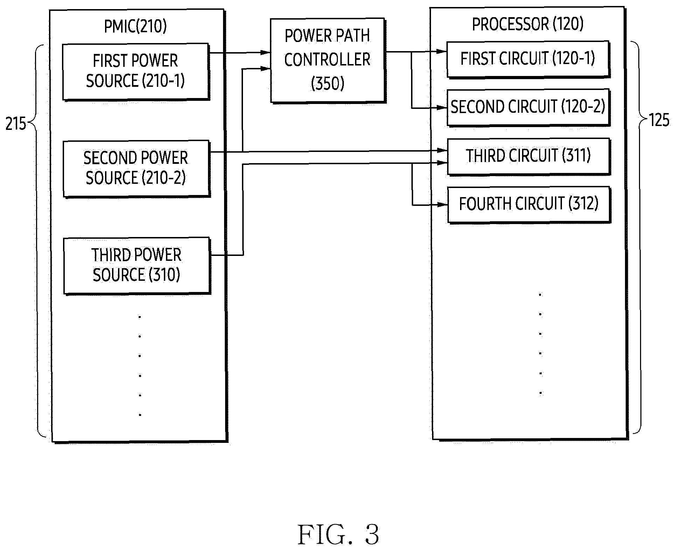

The processor 120 according to an embodiment may receive power for driving each of the circuits 125 by using the PMIC 210. An operation in which the processor 120 receives power from the power sources 215 of the PMIC 210 connected to each of the circuits 125 will be described later with reference to FIG. 3.

The processor 120 according to an embodiment, although not illustrated, may include a CPU memory unit (CMU) and/or a dynamic voltage frequency scaling (DVFS) controller. For example, the CMU may generate a clock (or frequency) signal. For example, the CMU may be an example of a clock generating device, including at least one of a phase locked loop (PLL), a delayed locked loop (DLL), or a crystal. By using the generated clock signal, the processor 120 may drive the circuits 125. For example, the processor 120 may adjust the frequency of the clock signal based on the control of the DVFS controller by using the CMU. For example, the processor 120 may control the CMU based on a designated governor (e.g., one of the governors 135) (or policy) by using the DVFS controller. For example, the processor 120 may adjust the frequency based on the governor (e.g., a first governor 130-1) by using the controlled CMU. For example, the governor 135 may include information about the policy for adjusting the frequencies used by the processor 120 to drive the circuits 125.

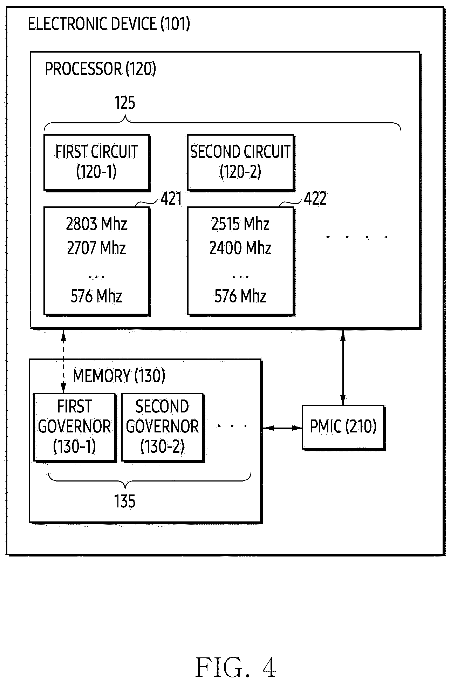

For example, the governor (e.g., at least one of the governors 135) is a program executed by the processor 120 to control the driver of the processor 120, and may be executed to adjust the frequencies of different circuits (e.g., or plurality of circuits) included in the processor 120. Based on the execution of the governor, the processor 120 may operate within a frequency range adjusted based on the resources and/or performance of the electronic device 101 occupied by the applications executed by the processor 120. An operation of changing a frequency by the electronic device 101 by using a governor will be described later in FIG. 4.

The memory 130 of the electronic device 101 according to an embodiment may include the hardware component for storing data and/or instructions input and/or output to the processor 120. The memory 130 may include, for example, volatile memory such as random-access memory (RAM) and/or non-volatile memory such as read-only memory (ROM). The volatile memory may include, for example, at least one of dynamic RAM (DRAM), static RAM (SRAM), Cache RAM, and pseudo SRAM (PSRAM). The non-volatile memory may include, for example, at least one of a programmable ROM (PROM), an erasable PROM (EPROM), an electrically erasable PROM (EEPROM), a flash memory, a hard disk, a compact disk, and an embedded multimedia card (eMMC).

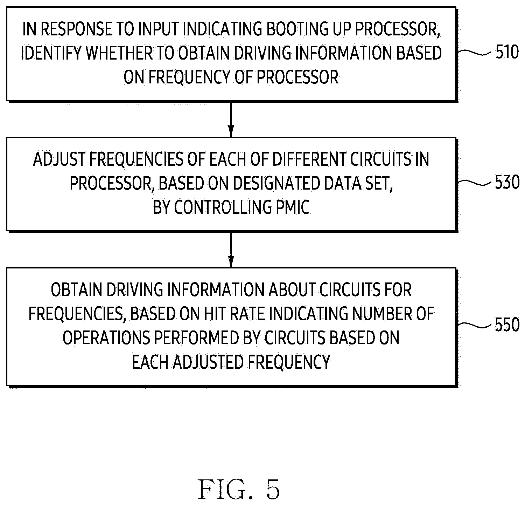

In the memory 130 of the electronic device 101 according to an embodiment, one or more instructions indicating an operation to be performed on data by the processor 120 may be stored. A set of instructions may be referred to as firmware, operating system, process, routine, sub-routine, and/or application. For example, the electronic device 101 and/or the processor 120 of the electronic device 101 may perform the operations of FIGS. 5 to 7 by executing a set of a plurality of instructions distributed in the form of an application.

The electronic device 101 according to an embodiment may include one or more governors 135 (or policy) in the memory 130. For example, by using the governors 135, the processor 120 may adjust frequencies (or clocks) to drive each of the circuits 125 included in the processor 120. For example, the governors 135 may include information about a target frequency for the processor 120 to perform at least one operation. For example, each of the governors 135 may include information about a frequency available to each of the circuits 125 included in the processor 120. For example, by using the first governor 130-1, the electronic device 101 may equally adjust the hit rate indicating the number of operations performed by each of the circuits 125 based on frequencies. For example, by using the second governor 130-2 (e.g., performance governor), the electronic device 101 may drive each of the circuits 125 by using a maximum frequency that each of the circuits 125 may allow. For example, by using one governor (e.g., powersaver governor which keeps CPU clock in the lowest state) among the governors 135, the electronic device 101 may drive each of the circuits 125 by using a minimum frequency that each of the circuits 125 may allow. For example, by using one governor (e.g., schedutil governor in which CPU clock is changed according to the load-rate of a scheduler) among the governors 135, the electronic device 101 may drive each of the circuits 125 based on adjusting frequencies based on a designated data set. An operation in which the electronic device 101 adjusts the hit rate by using the first governor 130-1 will be described later in FIG. 4.

The PMIC 210 of the electronic device 101 according to an embodiment may adjust power received from a battery (e.g., a battery 189 of FIG. 1). For example, the processor 120 may transmit information of a load that should be processed to the PMIC 210. The PMIC 210 may adjust power for transmitting to the processor 120 by using the information received from the processor 120. For example, the PMIC 210 may be disposed in an integrated circuit IC, the processor 120, or the SoC.

The power sources 215 included in the PMIC 210 according to an embodiment may establish a connection with respective circuits 125 for performing a plurality of functions of the processor 120, respectively. For example, at least some of the circuits 125 may share at least one power source. For example, the first circuit 120-1 and the second circuit 120-2 may establish a connection with one power source (e.g., the first power source 210-1). For example, the electronic device 101, may reduce the number of cables and/or the number of power sources (or capacitors) included in the electronic device 101, by establishing a connection at least some of the circuits 125 with one power source included in the PMIC 210.

According to an embodiment, the PMIC 210 may adjust the power (or voltage) transmitted from the power sources 215, based on the amount of data (or throughput) that the processor 120 processes by using some of the circuits 125. For example, the processor 120 may request the PMIC 210 to adjust the voltage level based on the obtained data throughput by using the DVFS controller. For example, the processor 120 may transmit signals necessary for each of the circuits 125 to perform an operation to the PMIC 210. For example, the circuits 125 may operate based on a frequency (or clock) signal. For example, the processor 120 may transmit information about at least some of the circuits 125 necessary to perform at least one operation to the PMIC 210. The PMIC 210 may transmit at least one clock signal to at least one circuit (e.g., the first circuit 120-1 or the second circuit 120-2) among the circuits 125 of the processor 120 based on the information. For example, the at least one clock signal may have a designated voltage. An operation for the electronic device 101 to adjust the designated voltage corresponding to the at least one clock signal will be described later in FIG. 3.

As described above, the probability of malfunction (or error) of the processor 120 may be different depending on the frequency of the processor 120. Based on the execution of the governor of the electronic device 101 (e.g., the first governor 130-1 among the governors 135 of FIG. 2) for adjusting the frequency, a method for more accurately obtaining a malfunction probability for each frequency may be required. In case of identifying the probability of malfunction by using a governor (the second governor 130-2 among the governors 135 of FIG. 2) that adjusts the frequency of the processor 120 based on performance and/or current, the probability of malfunction for a specific frequency may be identified with a lower accuracy than the probability of malfunction for another frequency (e.g., frequency used more frequently than the specific frequency). According to an embodiment, the electronic device 101 may reduce the deviation of the usage for each frequency in order to improve the accuracy of the malfunction probability for each frequency. Based on the reduced deviation, the electronic device 101 may more accurately identify the malfunction probability for each frequency. Hereinafter, in FIG. 3, based on the electronic device 101 identifying a power signal corresponding to a frequency for driving each of the circuits 125 included in the processor 120, an operation of transmitting the power signal to each of the circuits 125 by using the PMIC 210 will be described later.

FIG. 3 illustrates an exemplary circuit diagram illustrating a plurality of power sources included in a PMIC connected to each of the circuits included in the processor according to an embodiment. For example, a processor 120 may be referred to processor 120 of FIG. 1. For example, a PMIC 210 may be referred to the PMIC 210 of FIG. 2. For example, the processor 120 and/or the PMIC 210 may be included in an electronic device 101 of FIG. 1. The processor 120 according to an embodiment may receive, from the PMIC 210, a power signal for driving circuits 125. For example, the processor 120 may drive the circuits 125 based on a frequency (or clock signal) corresponding to the power signal, based on receiving the power signal.

Referring to FIG. 3, an electronic device (e.g., the electronic device 101 of FIG. 1) according to an embodiment may establish a connection, corresponding to each of power sources 215 included in the PMIC 210, to transmit power to each of the circuits 125 in the processor 120. For example, the electronic device 101 may establish a connection between at least some of the circuits 125 and one power source. For example, a first circuit 120-1 and a second circuit 120-2 may receive the power signal from a first power source 210-1 directly or via a power path controller (350). For example, the first circuit 120-1 and/or the second circuit 120-2 may be an example of a multi-core configuring the processor 120. For example, a third circuit 311 and a fourth circuit 312 may receive the power signal from a third power source 310. For example, the electronic device 101 may drive the third circuit 311 and the fourth circuit 312 based on the power signal output from the third power source 310.

For example, the processor 120 may perform at least one function by using the third circuit 311 and/or the fourth circuit 312. For example, at least one of the third circuit 311 and the fourth circuit 312 may be referred to one of internal memory (INT), camera (CAM), camera image sensor (CIS), or image signal processor (ISP).

For example, the electronic device 101 may transmit the power signal to a memory (e.g., volatile memory (SRAM)) included in the processor 120 by using a second power source 210-2. For example, some of the circuits 125 included in the processor 120 may include the memory. For example, the electronic device 101 may transmit the power signal to at least one of a power path controller 350 (or voltage controller) or the third circuit 311 by using the second power source 210-2. For example, the electronic device 101 may drive the memory included in some of the circuits 125 based on transmitting the power signal to the memory included in some of the circuits 125 by using the second power source 210-2.

The electronic device 101 according to an embodiment may use the power path controller 350 for transmitting the power signal from the first power source 210-1 and/or the second power source 210-2 to the first circuit 120-1 and/or the second circuit 120-2. For example, the electronic device 101 may transmit a plurality of power signals from some of the power sources 215 of the PMIC 210 to the power path controller 350. The electronic device 101 may compare the received plurality of power signals by using the power path controller 350. For example, the electronic device 101 may selectively transmit one of the power signals outputted from the first power source 210-1 and the second power source 210-2 by using the power path controller 350. For example, the electronic device 101 may transmit the first power signal to the first circuit 120-1 and/or the second circuit 120-2 in case that the voltage of the first power signal outputted from the first power source 210-1 is greater than or equal to the voltage of the second power signal outputted from the second power source 210-2. For example, the electronic device 101 may transmit the second power signal to the first circuit 120-1 and/or the second circuit 120-2 in case that the voltage of the second power signal outputted from the second power source 210-1 is greater than or equal to the voltage of the first power signal outputted from the first power source 210-1. However, it is not limited to the described above. For example, although not illustrated, the electronic device 101 may include a plurality of power path controller 350. For example, the power path controller 350 may be included in the processor 120 or disposed outside the processor 120.

According to an embodiment, the processor 120 may request the power signal corresponding to each of the frequencies used to drive each of the circuits 125 to each of the power sources 215, corresponding to each of the circuits 125. Hereinafter, it is assumed that the voltage of the power signal outputted from the first power source 210-1 includes a value greater than or equal to the voltage of the power signal outputted from the second power source 210-2. For example, the electronic device 101 may set the voltage of the power signal outputted from the first power source 210-1, based on frequencies for driving the first circuit 120-1 and the second circuit 120-2, respectively. For example, the electronic device 101 may transmit the power signal corresponding to a frequency that has a larger value among a frequency for driving the first circuit 120-1 and a frequency for driving the second circuit 120-2 from the PMIC 210, through the power path controller 350, to the first circuit 120-1 and/or the second circuit 120-2.

For example, the processor 120 may drive the second circuit 120-2 based on the second frequency (e.g., 768Mhz) while driving the first circuit 120-1 based on the first frequency (e.g., 2304Mhz). For example, the processor 120 may request the PMIC 210 to transmit the power signal corresponding to the first frequency (e.g., 2304Mhz) for driving the first circuit 120-1. For example, the processor 120 may receive the power signal corresponding to the first frequency (e.g., 2304Mhz) among the first frequency (e.g., 2304Mhz) or the second frequency (e.g., 768Mhz), from the first power source 210-1, through the power path controller 350. For example, the processor 120 may drive the first circuit 120-1 and/or the second circuit 120-2 by using the power signal received from the first power source 210-1.

According to an embodiment, the electronic device 101 may identify frequencies for driving each of the circuits 125 in the processor 120. For example, the electronic device 101 may identify the voltage of the power signal corresponding to each of the frequencies. For example, the electronic device 101 may transmit the first power signal (e.g., the power signal with the voltage of 1.4V) from the PMIC 210 to the first circuit 120-1 for driving the first circuit 120-1 based on the first frequency (e.g., 2304Mhz). For example, the voltage corresponding to the first frequency may be the voltage (e.g., 1.4V) of the first power signal.

For example, the electronic device 101 may transmit the second power signal (e.g., the power signal with the voltage of 800mV) from the PMIC 210 to the second circuit 120-2 for driving the second circuit 120-2 based on the second frequency (e.g., 768Mhz). For example, the voltage corresponding to the second frequency may be the voltage (e.g., 800 mV) of the second power signal. For example, the electronic device 101 may receive the first power signal from the first power source 210-1 to the first circuit 120-1 and the second circuit 120-2. For example, the electronic device 101, may drive the second circuit 120-2 based on the voltage (e.g., 1.4V) of the first power signal, which is more than the voltage (e.g., 800mV) corresponding to the second frequency (e.g., 768Mhz), while driving the first circuit 120-1 based on the first frequency (e.g., 2304Mhz) corresponding to the first power signal. Amount of power used while the electronic device 101 drives the second circuit 120-2 based on the second frequency may exceed the amount of power used during driving based on the voltage (e.g., 800 mV) corresponding to the second frequency. For example, the electronic device 101 may adjust the frequency by using one of the governors stored in the memory. An operation in which the electronic device 101 adjusts a frequency by using one of the governors will be described later in FIG. 4.

According to an embodiment, the processor 120 may drive the third circuit 311 and the fourth circuit 312 based on different frequencies. For example, the processor 120 may drive the fourth circuit 312 based on the fourth frequency while driving the third circuit 311 based on the third frequency. For example, the third frequency may be a frequency higher than the fourth frequency. The processor 120 may transmit a different signal for receiving the power signal corresponding to the third frequency from the third power source 310 to the PMIC 210. Based on receiving the different signal, the PMIC 210, may transmit the power signal corresponding to the third frequency to the third circuit 311 and/or the fourth circuit 312 by using the third power source 310.

According to an embodiment, the processor 120 may identify frequencies of some of the circuits 125 that receive the first power signal provided from the PMIC 210. The processor 120 may identify the first circuit 120-1 operating based on the first frequency (e.g., 2304Mhz) corresponding to the voltage of the first power signal among the circuits 125. The processor 120 may identify the second frequency (e.g., 768Mhz) of the second circuit 120-2. For example, the processor 120 may reduce the first frequency (e.g., 2304Mhz) of the first circuit 120-1 based on identifying that the voltage of the first power signal (e.g., 1.4V) exceeds the voltage (e.g., 800mV) corresponding to the second frequency (e.g., 768Mhz). The processor 120 may adjust the voltage of the first power signal to the voltage (e.g., 800 mV) corresponding to the second frequency based on the reduced first frequency (e.g., a frequency which is less than or equal to 768 MHz).

For example, the processor 120 may obtain a relationship between the voltage (e.g., 800mV) of the first power signal and the second frequency (e.g., 768Mhz) of the second circuit 120-2 after the voltage of the first power signal is adjusted by the reduced first frequency (e.g., a frequency which is less than or equal to 768 MHz).

For example, the processor 120 may drive each of the circuits 125 by using a second voltage having a value less than or equal to the first voltage corresponding to the frequency for driving each of the circuits 125. For example, the processor 120 may adjust the voltage corresponding to the second frequency while driving the second circuit 120-2 based on the second frequency (e.g., 768Mhz). For example, the processor 120 may drive the second circuit 120-2 based on receiving the power signal having the value less than or equal to the voltage (e.g., 800mV) corresponding to the second frequency (e.g., 768Mhz). For example, the processor 120 may identify margin of the voltage corresponding to the second frequency based on receiving the power signal. For example, based on the identifying of the margin of the voltage, the processor 120 may drive the circuits based on the frequency based on the second voltage that is less than or equal to the first voltage (e.g., 800mV) corresponding to each of the frequencies for driving each of the circuits 125.

According to an embodiment, the voltage of the power signal outputted from the second power source 210-2 may be the power signal corresponding to the highest frequency among frequencies (or clocks) for the processor 120 for driving the memory (e.g., SRAM) included in each of the first circuit 120-1, the second circuit 120-2, and the third circuit 311. Hereinafter, it is assumed that the voltage outputted from the second power source 210-2 includes a value greater than or equal to the voltage outputted from the first power source 210-1. For example, the processor 120 may adjust each of the frequencies for driving the first circuit 120-1 and the third circuit 311 for identifying the margin of the voltage corresponding to each of the frequencies for driving the second circuit 120-2.

For example, while the processor 120 drives the first circuit 120-1 based on the first frequency and drives the third circuit 311 based on the third frequency, the processor 120 may drive the second circuit 120-2 based on the second frequency. For example, the processor 120 may drive the first circuit 120-1, the second circuit 120-2, and the third circuit 311 based on receiving the first power signal corresponding to the first frequency from the second power source 210-2. For example, the voltage of the power signal outputted from the second power source 210-2 may be the voltage corresponding to the highest frequency among frequencies (or clocks) for the processor 120 for driving each of the first circuit 120-1, the second circuit 120-2, and the third circuit 311. For example, the first power signal may be an example of the power signal having a voltage greater than or equal to voltage corresponding to the second frequency and the voltage corresponding to the third frequency.

For example, the processor 120 may reduce the first frequency and the third frequency based on receiving the first power signal. For example, the processor 120 may reduce the first frequency and the third frequency to less than or equal to the second frequency. For example, the processor 120 may request the power signal corresponding to the second frequency to the PMIC 210 based on the reducing the first frequency and the third frequency. Based on the request, the PMIC 210 may transmit the second power signal, including the voltage corresponding to the second frequency, from the second power source 210-2 to the first circuit 120-1, the second circuit 120-2, and the third circuit 311.

For example, based on receiving the second power signal, the processor 120 may request the PMIC 210 to transmit a third power signal having a value less than the voltage of the second power signal for the second frequency in order to obtain the margin of the voltage of the second power signal for the second frequency. For example, the processor 120 may drive the second circuit 120-2 based on the second frequency based on receiving of the third power signal. The processor 120 may obtain a relationship (e.g., voltage margin) between the second power signal and the third power signal based on driving the second circuit 120-2 based on the third power signal.

As described above, the electronic device 101 according to an embodiment may obtain the margin of the voltage corresponding to each of the frequencies by adjusting each of the frequencies for driving each of the circuits 125. For example, some of the circuits 125 (e.g., the first circuit 120-1 and the second circuit 120-2) may establish a connection with one power source (e.g., the first power source 210-1) among the power sources 215 in order to receive the power signal. The electronic device 101 according to an embodiment may identify the margin of the voltage corresponding to frequencies for driving each of the plurality of circuits based on adjusting the frequency of each of the plurality of circuits (e.g., the first circuit 120-1 and the second circuit 120-2) that share the one power source (e.g., the first power source 210-1). Based on the identifying the margin of the voltage, the electronic device 101 may obtain an allowable range of voltage for driving each of the circuits 125.

FIG. 4 illustrates an exemplary state in which the processor of an electronic device according to an embodiment adjusts the frequency of each circuit included in the processor by using at least one governor. An electronic device 101 may be referred to the electronic device 101 of FIG. 1. A processor 120 may be referred to the processor 120 of FIG. 2. Circuits 125 may be referred to the circuits 125 of FIG. 2. A memory 130 may be referred to the memory 130 of FIG. 2.

Referring to FIG. 4, frequencies 421 and 422 for driving each of the circuits 125 included in the processor 120 are illustrated. For example, the processor 120 may drive a first circuit 120-1 by using frequencies included in a first frequency (e.g., 2803Mhz) to a second frequency (e.g., 576Mhz) (i.e., 2803 Mhz, 2707 Mhz, ..., 576 Hhz). For example, the processor 120 may drive a second circuit 120-2 based on frequencies included in a third frequency (e.g., 2515Mhz) to a fourth frequency (e.g., 576Mhz) (i.e., 2515 Hhz, 2400 Mhz, ..., 576 Mhz). For example, the electronic device 101 may drive each of the circuits 125 based on a data set for performing at least one function. For example, the data set may include information about frequency scheduling of frequencies (e.g., the frequencies 421 and 422) for driving each of the circuits 125. For example, the data set may include information indicating changes in frequencies according to a predetermined period. For example, the electronic device 101 may identify the data set corresponding to the at least one function. The electronic device 101 may adjust frequencies for driving each of the circuits 125 based on the identified data set. For example, the electronic device 101 may obtain the number of operations (e.g., hit rate) performed by each of the circuits 125 based on each of the adjusted frequencies. For example, the number of operations may be different depending on the frequencies.

The electronic device 101 according to an embodiment may identify whether to obtain driving information based on the frequency of the processor 120 in response to an input indicating booting up the processor 120. For example, the input indicating booting up the processor may be an example of an input indicating selecting a first governor 130-1. For example, in response to the input indicating selecting the first governor 130-1, the electronic device 101 may initiate booting up the processor 120. The electronic device 101 may obtain driving information based on frequency of the processor, while booting up the electronic device based on an input indicating selecting a governor (130-1) among governors (135). For example, the electronic device 101 may adjust frequencies of each of the circuits 125, based on a designated data set, by controlling a PMIC 210, in a designated state for obtaining the driving information. For example, the electronic device 101 may obtain the driving information on the circuits 125 for the frequencies, based on the hit rate indicating the number of operations performed by the circuits 125 based on each of the adjusted frequencies.

For example, based on identifying of completing the booting up the processor 120, the electronic device 101 may identify a threshold based on obtaining the driving information. Based on the identified threshold, the electronic device 101 may match the hit rate corresponding to each of the circuits 125 with the threshold, in a state different from the designated state for obtaining the driving information. By matching the hit rate with the threshold, the electronic device 101 may identify the frequency that causes the malfunction of the circuits 125 among the frequencies (e.g., the frequencies 421and 422) for driving each of the circuits 125.

The electronic device 101 according to an embodiment may obtain the number of operations (e.g., the hit rate) performed by the circuits 125 based on the frequencies (e.g., the frequencies 421 and 422) based on each of governors 135. Table 1 may include an example of the hit rate obtained by the electronic device 101 based on each of the governors 135.

**[Table 1]**

| Frequencies 421 (Mhz) of the first circuit 120-1 | Hit rate | | The frequencies 422 (Mhz) of the second circuit 120-2 | Hit rate | |
|---|---|---|---|---|---|
| | The first governor 130-1 | The second governor 130-2 | | The first governor 130-1 | The second governor 130-2 |
| 576 | 115 | 1318 | 576 | 129 | 792 |
| 672 | 115 | 133 | 672 | 129 | 65 |
| 789 | 115 | 32 | 768 | 129 | 26 |
| ... | ... | ... | ... | ... | ... |
| 2616 | 115 | 144 | 2304 | 129 | 28 |
| 2707 | 115 | 122 | 2400 | 129 | 32 |
| 2803 | 115 | 301 | 2515 | 129 | 1300 |

Referring to Table 1, the electronic device 101 according to an embodiment may identify the hit rate for each of the circuits 125 based on the frequencies (e.g., the frequencies 421 and 422) by using one governor among the governors 135 while performing at least one function. The information on the frequencies applied to a specific circuit as shown in [Table 1] is considered as driving information. For example, the electronic device 101 may drive each of the circuits 125 based on the scheduling of the frequencies (e.g., the frequencies 421 and 422) while performing at least one function by using the second governor 130-2. While performing the at least one function, the hit rate obtained by using the second governor 130-2 may be different depending on the frequency. For example, the electronic device 101 may obtain the hit rate (e.g., 1318) for the first frequency (e.g., 576Mhz) for driving the first circuit 120-1 by using the second governor 130-2 while performing the at least one function. The electronic device 101 may obtain the hit rate (e.g., 32) for the second frequency (e.g., 789Mhz) while obtaining the hit rate for the first frequency. However, it is not limited thereto. For example, the at least one function performed by the electronic device 101 by using the second governor 130-2 may mean booting up the processor 120. For example, the electronic device 101 may store the hit rate of each of the circuits 125 obtained by using the second governor 130-2, in the memory 130. For example, the electronic device 101 may identify at least one value among the hit rates stored in the memory 130 as the threshold based on identifying completion of the booting up.

For example, based on identifying completion of the booting up, the electronic device 101 may match the hit rate for frequencies (e.g., the frequencies 421 and 422) for driving each of the circuits 125 with the threshold, while performing a different function (e.g., frequency detection) from the at least one function (e.g., booting) by using the first governor 130-1. For example, the electronic device 101 may obtain a hit rate (e.g., 129) having the same value for each of the frequencies for driving the first circuit 120-1, based on matching the threshold with the hit rate. Based on obtaining the hit rate (e.g., 129) having the same value, the electronic device 101 may identify the frequency that causes the malfunction of the first circuit 120-1 among the frequencies 421 for driving the first circuit 120-1. For example, the malfunction may occur while the electronic device 101 drives the first circuit 120-1 by using a frequency (e.g., 768Mhz) having the smallest hit rate (e.g., 32) among the frequencies 421 used to drive the first circuit 120-1. For example, the electronic device 101 may identify the malfunction by driving the first circuit 120-1 based on the frequency (e.g., 768Mhz) by using the first governor 130-1.

The electronic device 101 according to one embodiment may drive the second circuit 120-2 based on the second frequency (e.g., 2515Mhz) while driving the first circuit 120-1 based on the first frequency (e.g., 2616Mhz). For example, the first circuit 120-1 and the second circuit 120-2 may receive the same first power signal from the first power source 210-1 of FIG. 3. The first power signal may be an example of the power signal corresponding to the first frequency (e.g., 2616Mhz). For example, the electronic device 101 may adjust the second frequency by using one governor (e.g., the first governor 130-1) among the governors 135. For example, the electronic device 101 may adjust the second frequency (e.g., 2515Mhz) to the third frequency (e.g., 576Mhz), while the first circuit 120-1 and the second circuit 120-2 are driven based on the first frequency (e.g., 2616Mhz) and/or the second frequency (e.g., 2515Mhz), based on the first power signal. For example, the electronic device 101 may obtain data indicating the interaction between the first circuit 120-1, the second circuit 120-2, and the first power source 210-1 of FIG. 3., based on driving the first circuit 120-1, based on the first frequency (e.g., 2616Mhz), while driving the second circuit 120-2 based on the adjusted third frequency (e.g., 576 Mhz) by using the first power signal. The data may include information about the malfunction according to a difference in frequencies for each of the circuits 125 sharing the same power source. For example, the electronic device 101 may obtain skew information about the power signal (or clock) transmitted to each of the first circuit 120-1 and the second circuit 120-2 from the power source (e.g., the first power source 210-1 of FIG. 3) by adjusting frequencies for driving each of the first circuit 120-1 and the second circuit 120-2. For example, the information may include information about a delay for the power signal transmitted to each of the first circuit 120-1 and the second circuit 120-2.

As described above, the electronic device 101 may use the first governor 130-1 in order to identify frequencies that cause malfunctions. The electronic device 101 may equally match the hit rates for the frequencies (e.g., the frequencies 421 and 422) for driving each of the circuits 125 by using the first governor 130-1. One circuit among the circuits 125 may be driven, by using a frequency having a small usage, based on matching the hit rates equally. For example, the electronic device 101 may identify malfunctions according to the frequency having a small usage, by using the driven one circuit. The electronic device 101 may more accurately identify the malfunction probability for each frequency, by using the first governor 130-1. The electronic device 101 may provide the user with information about the frequency that causes the malfunction by equally matching the hit rate for each of the frequencies for driving each of the circuits 125, by using the first governor 130-1.

FIG. 5 illustrates an exemplary flowchart illustrating an operation in which an electronic device according to an embodiment obtains a hit rate based on receiving one input. At least one operation among the operations of FIG. 5 may be performed by an electronic device 101 and/or a processor 120 of FIG. 1.

Referring to FIG. 5, in operation 510, a processor according to an embodiment may identify whether to obtain driving information based on a frequency of the processor in response to an input indicating booting up the processor. For example, the input indicating booting up the processor may correspond to an input indicating initiating execution of a first governor (e.g., a first governor 130-1 of FIG. 2) among governors (e.g., governors 135 of FIG. 2) stored in a memory (e.g., a memory 130 of FIG. 2). For example, the processor may initiate booting to initialize a hit rate (e.g., a hit rate of FIG. 4) for the frequency based on the execution of the first governor.

Referring to FIG. 5, by control a PMIC in operation 530, the processor according to an embodiment may adjust (or change) the frequencies of each of the different circuits(or a plurality of circuits) in the processor based on a designated data set. Throughout the description, the term "adjust" can be understood as "change" interchangeably. For example, the PMIC may be referred to a PMIC 210 of FIG. 2. The designated data set may include information about scheduling of frequencies for driving each of the circuits (e.g., circuits 125 of FIG. 2) in order for the electronic device to perform at least one function. For example, the designated data set may be an example of a data set obtained from a governor different from the first governor (e.g., the first governor 130-1 of FIG. 2). For example, the different circuits in the processor may be referred to the circuits 125 of FIG. 2. The frequencies may be referred to frequencies 421 and 422 of FIG. 4. For example, the processor may request a power signal corresponding to the frequencies to the PMIC. For example, the processor may drive each of the circuits based on each of the frequencies based on the power signal received from the PMIC.

Referring to FIG. 5, in operation 550, the processor according to an embodiment may obtain driving information about circuits for frequencies based on the hit rate indicating the number of operations performed by the circuits for each of the adjusted frequencies. For example, the processor may transmit the driving information to the memory. The transmitted driving information may be stored in a memory. The processor may identify at least one value (e.g., a threshold) among the hit rates by using driving information stored in the memory.

For example, the processor may identify completion of booting up. Based on identifying the completion of the booting up, the processor may match each of the hit rates for the frequencies to the one value (e.g., the threshold) by using the first governor (e.g., the first governor 130-1 of FIG. 2). The processor may obtain the hit rate having the same value by matching each of the hit rates with the one value (e.g., the threshold). For example, the processor may identify frequencies that cause malfunction of each of the circuits (e.g., the circuits 125 of FIG. 2) based on obtaining the hit rate having the same value.

As described above, the electronic devices 101 and/or the processor 120 may identify driving information about each of the circuits 125 by using the first burner 130-1, in response to an input indicating that the same hit rate for frequencies is obtained. The electronic device 101 and/or the processor 120 may identify the malfunction of each of the circuits 125 for some of the frequencies based on the driving information. The electronic device 101 and/or the processor 120 may provide information about the identified malfunction to the user.

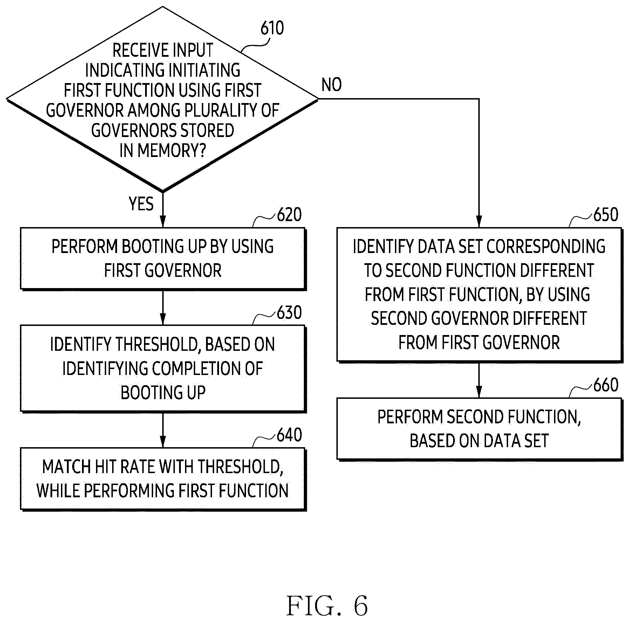

FIG. 6 illustrates an exemplary flowchart illustrating an operation in which an electronic device according to an embodiment detects a malfunction by using a governor. At least one operation among the operations of FIG. 6 may be performed by an electronic device 101 and/or a processor 120 of FIG. 1.

Referring to FIG. 6, in operation 610, the processor according to an embodiment may identify whether an input indicating initiating a first function using a first governor among a plurality of governors stored in a memory has been received. For example, the memory may be referred to a memory 130 of FIG. 1. The plurality of governors may be referred to governors 135 of FIG. 2. The first governor may be referred to a first governor 130-1 of FIG. 2. The first function may mean a function of adjusting each of frequencies for driving each of a plurality of circuits (e.g., circuits 125 of FIG. 2) included in the processor.

Referring to FIG. 6, in case that the processor according to an embodiment receives the input (the operation 610-yes), in operation 620, the processor may perform booting up by using the first governor. For example, based on the booting up, the processor may initialize usage of each of the frequencies for driving each of the circuits (e.g., the circuits 125 of FIG. 2).

Referring to FIG. 6, in operation 630, the processor according to an embodiment may identify a threshold based on identifying completion of the booting up. For example, while performing the booting up, the processor may obtain a hit rate indicating the number of times that each of the circuits (e.g., the circuits 125 of FIG. 2) is driven based on each of the frequencies. The processor may identify one value among the obtained hit rates as the threshold, based on identifying the completion of the booting up.

Referring to FIG. 6, in operation 640, the processor according to an embodiment may match the hit rate with the threshold while performing the first function. For example, the processor may drive circuits based on a frequency having a small usage by matching the hit rate with the threshold. For example, while performing the first function, the processor may reduce the deviation of the usage for each frequency by driving the circuits based on the frequency having a small usage.

Referring to FIG. 6, in case that the input indicating initiating the first function using the first governor is not received (the operation 610-no), in operation 650, the processor according to an embodiment may identify a data set corresponding to a second function different from the first function, by using a second governor different from the first governor. For example, the second governor may correspond to a second governor 130-2 of FIG. 2. For example, the processor may perform the second function by using one application included in the electronic device (e.g., the electronic device 101 of FIG. 1). For example, the one application may be an example of a game application and/or an application for playing a video. For example, the data set may include information about scheduling of frequencies corresponding to the one application.

Referring to FIG. 6, in operation 660, the processor according to an embodiment may perform the second function based on the data set. For example, the processor may drive each of the circuits (e.g., the circuits 125 of FIG. 2) based on the scheduling of the frequencies while performing the second function by using the second governor (e.g., the second governor 130-2 of FIG. 2). For example, in case of driving each of the circuits based on the scheduling of the frequencies, the usage of the frequencies of the processor may be different. In case that the processor identifies the malfunction by using the second governor (e.g., the second governor 130-2 of FIG. 2), the probability of the malfunction for a specific frequency may be identified with a lower accuracy than the probability of the malfunction for another frequency (e.g., frequency used more frequently than the specific frequency).

As described above, the electronic device (e.g., the electronic devices 101 of FIG. 1) and/or the processor (e.g., the processor 120 of FIG. 1) may provide information about the malfunction to the user by using at least one application (e.g., a user self-diagnosis application). The electronic device and/or the processor may receive the input indicating initiating execution of the first governor (e.g., the first governor 130-1 of FIG. 2) by using the at least one application. The electronic device and/or the processor may obtain the hit rate having the same value corresponding to frequencies for driving each of the circuits in the processor, by using the first governor. The electronic device and/or the processor may obtain information about frequencies that cause the malfunction of each of the circuits, while obtaining the hit rate. The electronic device and/or the processor may identify the malfunction with a higher accuracy than the probability of the malfunction obtained by using the second governor, by reducing the deviation of the usage of frequencies by using the first governor. The electronic device and/or the processor may provide information about frequencies causing the malfunction to the user.

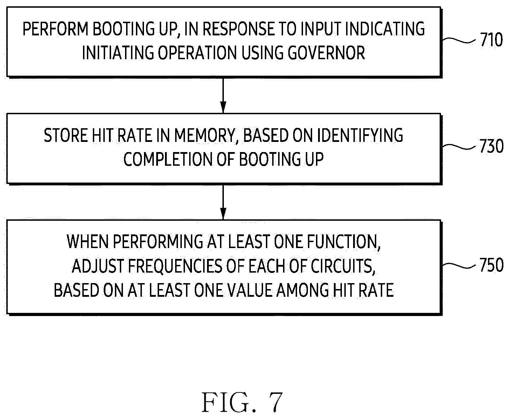

FIG. 7 illustrates an exemplary flowchart illustrating an operation in which an electronic device according to an embodiment adjusts a hit rate by using a governor. At least one operation among the operations of FIG. 7 may be performed by an electronic device 101 and/or a processor 120 of FIG. 1.

Referring to FIG. 7, in operation 710, the processor according to an embodiment may perform booting up, in response to an input indicating initiating the operation by using the governor. For example, the governor may be referred to a first governor 130-1 of FIG. 2. The operation may be an example of an operation for detecting a frequency that causes a malfunction of circuits included in the processor, among frequencies of the processor.

Referring to FIG. 7, in operation 730, the processor according to an embodiment may store a hit rate in a memory based on identifying completion of booting up. For example, the hit rate may mean the number of operations performed by the circuits based on each of the frequencies. For example, the processor may obtain the hit rate having various values for an operation performing the booting up, for the frequencies. The processor may identify one value among the hit rates as a threshold based on identifying the completion of the booting up.

Referring to FIG. 7, in operation 750, when performing at least one function, the processor according to an embodiment may adjust frequencies of each of the circuits, based on at least one value among the hit rates. For example, at least one value among the hit rates may correspond to the threshold. For example, the processor may match the hit rate different from the hit rate obtained when performing the at least one function to the threshold. For example, the processor may identify the frequency that causes the malfunction of each circuit, based on matching the hit rate to the threshold by using a first governor (e.g., the first governor 130-1 of FIG. 2). For example, the processor may identify the malfunction, by driving respective circuits based on the identified frequency.

As described above, the processor may store first hit rates for the frequencies of the processor, by performing booting up by using the governor (e.g., the first governor 130-1). The processor may obtain a second hit rates, based on performing a function different from the booting up. The processor may adjust the obtained second hit rates, by using one value among the stored first hit rates. For example, the processor may adjust the frequencies corresponding to the second hit rates based on the adjustment of a power signal outputted from a PMIC (e.g., a PMIC 210 of FIG. 2). For example, the processor may reduce the deviation of the usage for each frequency based on matching the second hit rate to the one value. Based on the reduced deviation, the processor may identify one of the circuits performing the malfunction. The processor according to an embodiment may provide information about the malfunction to the user.

The electronic device according to an embodiment may drive circuits included in the processor based on various frequencies. The electronic device may obtain information about the frequencies having a small usage, by adjusting the usage of frequencies for driving the circuits.

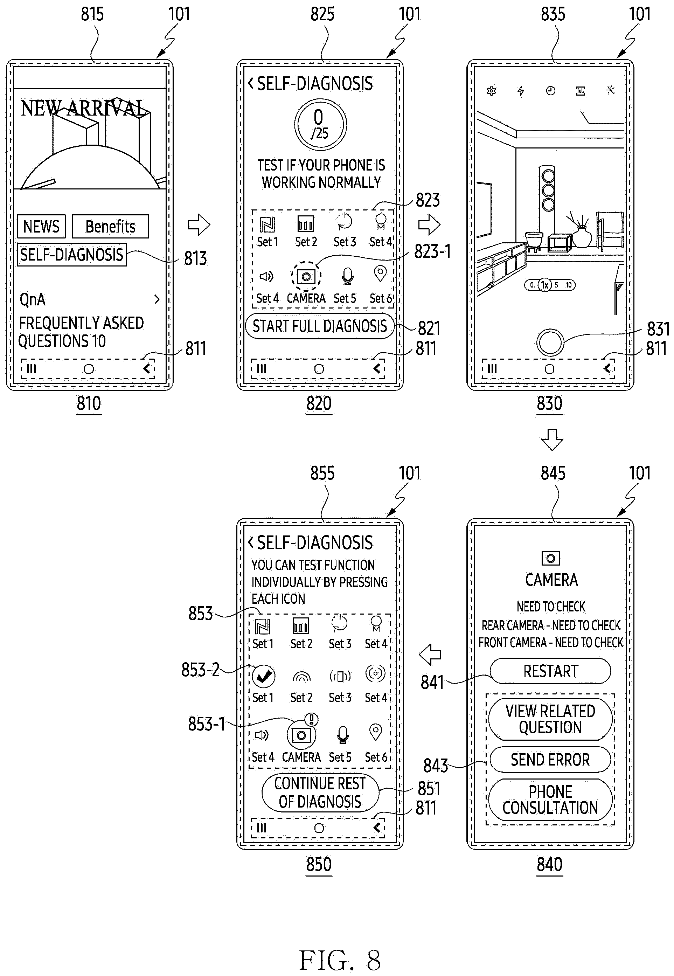

FIG. 8 illustrates exemplary states in which an electronic device according to an embodiment identifies a malfunction based on at least one application. An electronic device 101 may be an example of the electronic device 101 of FIG. 1 and/or the electronic device 101 of FIG. 2.

In a state 810, the electronic device 101 according to an embodiment may display a screen 815 based on at least one application, through a display. For example, the screen 815 may include a navigation bar 811. For example, the navigation bar 811 may include at least one of a first button (e.g., a menu button), a second button (e.g., a home button), and/or a third button (e.g., a back button). For example, the electronic device 101 may provide a connection menu that may be displayed on the display by using the first button (e.g., the menu button). The connection menu may include adding a widget, changing a wallpaper, searching, editing, and/or environment setting menus. For example, in case that a plurality of applications are executed, the electronic device 101 may display trays of the plurality of applications being executed, in response to an input for selecting the first button. For example, the electronic device 101 may receive an input for selecting the second button. The electronic device 101 may display a screen based on at least one application based on the input for selecting the second button (e.g., the home button). For example, the electronic device 101 may control one or more applications stored in a memory, based on the screen. For example, the electronic device 101 may receive an input for selecting the third button (e.g., the back button). The electronic device 101 may display a previously stacked screen of a screen displayed on the display, based on the input for selecting the third button.

The electronic device 101 according to an embodiment may display a visual object 813 on the screen 815. The electronic device 101 may receive an input indicating the execution of a first governor 130-1 of FIG. 2, by using the visual object 813. For example, the electronic device 101 may initiate the execution of the first governor 130-1, in response to the input.

In a state 820, the electronic device 101 according to an embodiment may display a screen 825, in response to the input indicating the execution of the first governor 130-1, by using the visual object 813. For example, the screen 825 may include visual objects 823 corresponding to one or more functions executable by the electronic device 101 and/or the processor (e.g., a processor 120 of FIG. 2). The electronic device 101 may receive an input indicating that one or more functions corresponding to the visual objects 823 are executed based on the first governor 130-1 by using a visual object 821. The electronic device 101 may drive one or more functions, executable in the electronic device 101, based on the first governor 130-1, in response to the input. For example, the electronic device 101 may drive a function (e.g., a camera function) corresponding to a visual object 823-1 based on the first governor 130-1, in response to an input indicating that the visual object 823-1 is selected among the visual objects 823. However, it is not limited thereto.

For example, the electronic device 101 may perform booting up, in response to an input indicating selecting the visual object 821, and/or the visual object 823-1. The electronic device 101 may obtain a hit rate, as the booting up is performed based on the first governor (e.g., the first governor 130-1 of FIG. 2).

The electronic device 101 according to an embodiment may store the hit rate in the memory based on identifying the completion of the booting up based on the first governor (e.g., the first governor 130-1 of FIG. 2). For example, in a state 830, the electronic device 101 may drive the function (e.g., the camera function corresponding to the visual object 823-1) corresponding to at least one of the visual objects 823 based on identifying the completion of the booting up. The electronic device 101 may display a screen 835, based on at least one function. The electronic device 101 may identify a frequency that causes the malfunction among the frequencies of the processor 120 by performing at least one function, based on the first governor (e.g., the first governor 130-1 of FIG. 2). For example, the electronic device 101 may perform the at least one function, by changing the frequencies, based on the first governor (e.g., the first governor 130-1 of FIG. 2). For example, the electronic device 101 may perform the at least one function, based on the first governor, in response to an input indicating selecting a visual object 831. However, it is not limited thereto.

In a state 840, the electronic device 101 according to an embodiment may provide the user whether the frequency causing the malfunction has been identified by completing the performance of at least one function based on the first governor (e.g., the first governor 130-1 of FIG. 2), by using a screen 845. For example, the electronic device 101 may initiate the performance of the at least one function based on the first governor, in response to an input indicating selecting a visual object 841. For example, the electronic device 101 may display a screen 855 on the display, in a state 850, in response to the input indicating selecting the visual object 841. For example, the electronic device 101 may initiate booting up, based on the first governor, in response to the input indicating selecting the visual object 841.

For example, the electronic device 101 may transmit information about the frequency causing the malfunction to at least one server, in response to an input indicating that at least one of the visual objects 843 is selected. For example, the electronic device 101 may display information about the malfunction, which is available by the user of the electronic device 101, on the display, in response to the input indicating that at least one of the visual objects 843 is selected. However, it is not limited thereto.

The electronic device 101 according to one embodiment may display the screen 855 on the display in the state 850, based on completing the performance of at least one function based on the first governor (e.g., the first governor 130-1 of FIG. 2). For example, the screen 855 may include information included in the screen 825. The screen 855 may include visual objects 853 corresponding to functions executable by the electronic device 101 and/or the processor 120. The electronic device may display a visual object 853-1 and/or a visual object 853-2 indicating the completion of the performance of a function corresponding to at least one of the visual objects 853 based on the first governor (e.g., the first governor 130-1 of FIG. 1), by using the screen 855. The visual object 853-1 may indicate that the performance of the function (e.g., the camera function) corresponding to the visual object 853-1 based on the first governor (e.g., the first governor 130-1 of FIG. 2) causes the malfunction. The visual object 853-2 may indicate that the performance of the function corresponding to the visual object 853-2 based on the first governor does not cause the malfunction. For example, the electronic device 101 may initiate the operation of some functions that have not initiated the performance of functions based on the first governor, among the functions corresponding to the visual objects 853, based on the first governor, in response to an input indicating selecting a visual object 851. However, it is not limited thereto.

As described above, the electronic device 101 may provide the user with a self-diagnosis mode based on the first governor (e.g., the first governor 130-1 of FIG. 2). For example, the electronic device 101 may perform one or more functions executable by the electronic device 101 based on the first governor (e.g., the first governor 130-1 of FIG. 2). The electronic device 101 may identify a frequency corresponding to each of the frequencies of the processor and causing the malfunction by performing the one or more functions based on the first governor (e.g., the first governor 130-1 of FIG. 2). Based on the identified frequency, the electronic device 101 may identify at least one function that causes the malfunction, among the one or more functions. The electronic device 101 may provide information about the identified at least one function to the user. The electronic device 101 may provide user convenience by providing the information to the user.

As described above, an electronic device according to an embodiment (e.g., an electronic device 101 of FIG. 1) may comprise a power management integrated circuit (PMIC) (e.g., a PMIC 210 of FIG. 2), a memory (e.g., a memory 130 of FIG. 1), and a processor (e.g., a processor 120 of FIG. 1). The processor may identify whether to obtain driving information based on frequency of the processor, in response to an input indicating booting up the processor. The processor may change frequencies (e.g., frequencies 421 and 422 of FIG. 4) of each of the a plurality of circuits (e.g., circuits 125 of FIG. 2) in the processor by using a designated data set including information about scheduling of frequencies for driving each of the plurality of circuits, by controlling the PMIC, in a designated state for obtaining the driving information based on frequency of the processor. The processor may obtain the driving information on the plurality of circuits in the processor about the frequencies, based on hit rate indicating number of operations performed by the plurality of circuits for each of the changed frequencies.

For example, the designated state may be a first state. The processor may identify a threshold, based on completion of the booting up the processor. The processor may match the hit rate with the threshold, in a second state for performing other function distinct from a function for obtaining the driving information. The processor may be configured to identify a frequency causing a malfunction of the other function among the frequencies, by using the hit rate.

For example, the processor may store the driving information, in the memory. The processor may identify the threshold as a value corresponding to at least one among the hit rates, based on the driving information.

For example, the data set includes information indicating a change of a frequency according to a period for controlling each of the plurality of circuits, based on that the processor performs the booting up.

For example, the processor may identify frequencies of the plurality of circuits receiving a power signal provided from the PMIC. The processor may identify a first circuit (e.g., a first circuit 120-1 of FIG. 2) operating based on a first frequency corresponding to voltage of the power signal among the plurality of circuits. The processor may identify a second frequency of a second circuit (e.g., a second circuit 120-2) different from the first circuit, among the plurality of circuits. The processor may reduce the first frequency of the first circuit, based on identifying that the voltage of the power signal exceeds voltage corresponding to the second frequency. The processor may change the voltage of the power signal, based on the reduced first frequency.

For example, the processor may obtain a relationship between the voltage of the power signal and the second frequency of the second circuit, after the voltage of the power signal is changed by the reduced first frequency.

For example, the power signal may be a first power signal. The processor may transmit a second power signal different from the first power signal to a third circuit (e.g., a third circuit 311 of FIG. 3) different from a first circuit and a second circuit among the plurality of circuits, from a second power source (e.g., a second power source 210-2 of FIG. 3) different from a first power source (e.g., a first power source 210-1 of FIG. 3) transmitting the first power signal to the first circuit and the second circuit, wherein the first power source and the second power source are included in the PMIC. The processor may drive the third circuit, based on a third frequency corresponding to the received second power signal. The processor may reduce the third frequency based on reducing the first frequency of the first circuit.

For example, the processor may obtain data indicating an interaction between a frequency for driving the first circuit and a frequency for driving the second circuit. The processor may be configured to identify a delay about the power signal, based on the data indicating the interaction.

For example, the data indicating the interaction may include information indicating difference between the first frequency and the second frequency.

For example, the processor may obtain the data indicating the interaction, based on changing at least one frequency of the first frequency and the second frequency.

As described above, the electronic device (e.g., the electronic device 101 of FIG. 1) method according to an embodiment may comprise identifying whether to obtain driving information based on frequency of a processor, in response to an input indicating booting up the processor (e.g., the processor 120 of FIG. 1). The method may comprise changing frequencies (e.g., frequencies 421 and 422) of each of a plurality of circuits (e.g., circuits 125 of FIG. 2) in the processor by using a designated data set including information about scheduling of frequencies for driving each of the plurality of circuits, by controlling a power management integrated circuit (PMIC) (e.g., a PMIC 210 of FIG. 2), in a designated state for obtaining the driving information based on frequency of the processor. The method may comprise obtaining the driving information on the plurality of circuits in the processor about the frequencies, based on hit rate indicating number of operations performed by the plurality of circuits for each of the changed frequencies by the circuits.

For example, the designated state may be a first state. The obtaining the driving information on the circuits may comprise identifying a threshold, based on identifying completion of the booting up the processor. The obtaining the driving information on the plurality of circuits may comprise matching the hit rate with the threshold, in a second state for performing other function distinct from a function for obtaining the driving information. The obtaining the driving information on the circuits may comprise identifying a frequency causing a malfunction of the other function among the frequencies, by using the hit rate.

For example, the identifying whether to obtain driving information comprise storing the driving information, in the memory. The identifying whether to obtain driving information identifying the threshold as a value corresponding to at least one among the hit rates, based on the driving information.

For example, the changing the frequencies may comprise identifying frequencies of the plurality of circuits receiving a power signal provided from the PMIC. The changing the frequencies may comprise identifying a first circuit (e.g., a first circuit 120-1 of FIG. 2) operating based on a first frequency corresponding to voltage of the power signal among the plurality of circuits. The changing the frequencies may comprise identifying a second frequency of a second circuit (e.g., a second circuit 120-2) different from the first circuit, among the plurality of circuits. The changing the frequencies may comprise reducing the first frequency of the first circuit, based on identifying that the voltage of the power signal exceeds voltage corresponding to the second frequency. The changing the frequencies may comprise changing the voltage of the power signal, based on the reduced first frequency.

For example, the reducing the first frequency may comprise obtaining a relationship between the voltage of the power signal and the second frequency of the second circuit, after the voltage of the power signal is changed by the reduced first frequency.

For example, the power signal may be a first power signal. The reducing the first frequency may comprise transmitting a second power signal different from the first power signal to a third circuit (e.g., a third circuit 311 of FIG. 3) different from a first circuit and a second circuit among the plurality of circuits, from a second power source (e.g., a second power source 210-2 of FIG. 3) different from a first power source (e.g., a first power source 210-1 of FIG. 3) transmitting the first power signal to the first circuit and the second circuit, wherein the first power and the second power source are included in the PMIC. The reducing the first frequency may comprise driving the third circuit, based on a third frequency corresponding to the received second power signal. The reducing the first frequency may comprise reducing the third frequency based on reducing the first frequency of the first circuit.

For example, the identifying frequencies of the plurality of circuits may comprise obtaining data indicating an interaction between a frequency for driving the first circuit and a frequency for driving the second circuit.

For example, the data indicating the interaction may include information indicating difference between the first frequency and the second frequency.

For example, the obtaining data may comprise obtaining the data indicating the interaction, based on changing at least one frequency of the first frequency or the second frequency.

For example, the data set may include information indicating a change of a frequency according to a period for controlling each of the plurality of circuits, based on that the processor perform the booting up.

As described above, a computer readable storage medium storing one or more programs according to an embodiment, wherein the one or more programs may, when executed by a processor (e.g., a processor 120 of FIG. 1) of an electronic device (e.g., an electronic device 101 of FIG. 1), identify whether to obtain driving information based on frequency of the processor, in response to an input indicating booting up the processor. The one or more programs, when executed by a processor, may change frequencies (e.g., frequencies 421 and 422 of FIG. 4) of each of a plurality of circuits (e.g., circuits 125 of FIG. 2) in the processor by using a designated data set including information about scheduling of frequencies for driving each of the plurality of circuits, by controlling a power management integrated circuit (PMIC) (e.g., a PMIC 210 of FIG. 2), in a designated state for obtaining the driving information based on frequency of the processor. The one or more programs, when executed by a processor, may obtain the driving information on the plurality of circuits in the processor about the frequencies, based on hit rate indicating number of operations performed by the plurality of circuits for each of the changed frequencies.

For example, the designated state may be a first state. The one or more programs, when executed by the processor, may identify a threshold, based on identifying completion of the booting up the processor. The one or more programs, when executed by the processor, may match the hit rate with the threshold, in a second state for performing other function distinct from a function for obtaining the driving information. The one or more programs, when executed by the processor, may identify a frequency causing a malfunction of the other function among the frequencies, by using the hit rate. For example, the one or more programs, when executed by the processor of the electronic device, may store the driving information, in the memory. The one or more programs may identify the threshold as a value corresponding to at least one among the hit rates, based on the driving information.

For example, the one or more programs, when executed by the processor of the electronic device, may store the driving information, in the memory. The one or more programs may identify the threshold as a value corresponding to at least one among the hit rates, based on the driving information.

For example, the data set may include information indicating a change of a frequency according to a period for controlling each of the plurality of circuits, based on that the processor perform the booting up.

For example, the one or more programs, when executed by the processor, may identify frequencies of the plurality of circuits receiving a power signal provided from the PMIC. The one or more programs, when executed by the processor, may identify a first circuit (e.g., a first circuit 120-1 of FIG. 2) operating based on a first frequency corresponding to voltage of the power signal among the plurality of circuits. The one or more programs, when executed by the processor, may identify a second frequency of a second circuit (e.g., a second circuit 120-2) different from the first circuit, among the plurality of circuits. The one or more programs, when executed by the processor, may reduce the first frequency of the first circuit, based on identifying that the voltage of the power signal exceeds voltage corresponding to the second frequency. The one or more programs, when executed by the processor, may change the voltage of the power signal, based on the reduced first frequency.

For example, the one or more programs, when executed by the processor may obtain a relationship between the voltage of the power signal and the second frequency of the second circuit, after the voltage of the power signal is changed by the reduced first frequency.

For example, the one or more programs, when executed by the processor, may transmit a second power signal different from the first power signal which is the power signal, to a third circuit (e.g., a third circuit 311 of FIG. 3) different from a first circuit and a second circuit among the plurality of circuits, from a second power source (e.g., a second power source 210-2 of FIG. 3) different from a first power source (e.g., a first power source 210-1 of FIG. 3) transmitting the power signal to the first circuit and the second circuit included in the PMIC. The one or more programs may drive the third circuit, based on a third frequency corresponding to the received second power signal. The one or more programs may reduce the third frequency based on identifying reducing the first frequency of the first circuit.

For example, the one or more programs, when executed by the processor, may obtain data indicating an interaction between a frequency for driving the first circuit and a frequency for driving the second circuit. The one or more programs, when executed by the processor, may identify a delay in the power signal, based on the data indicating the interaction.

For example, the data indicating the interaction may include information indicating difference between the first frequency and the second frequency.

For example, the one or more programs, when executed by the processor, may obtain the data indicating the interaction, based on changing at least one frequency of the first frequency and the second frequency.

As described above, an electronic device (e.g., an electronic device 101 of FIG. 1) according to an embodiment may comprise a power management integrated circuit (PMIC) (e.g., a PMIC 210 of FIG. 2), a memory (e.g., a memory 130 of FIG. 1), and a processor (e.g., a processor 120 of FIG. 1). The processor may be configured to obtain driving information based on frequency of the processor, while booting up the electronic device based on an input indicating selecting a governor (130-1) among governors (135) including information for adjusting frequencies used to drive to a plurality of circuit (125) of the processor. The processor may be configured to change frequencies (421; 422) of each of the plurality of circuits in the processor by using a designated data set including information about scheduling of frequencies for driving each of the plurality of circuits, by controlling the PMIC, in a designated state for obtaining driving information based on frequency of the processor by using selected the governor. The processor may be configured to obtain the driving information on the plurality of circuits in the processor corresponding to the changed frequencies, based on hit rate indicating number of operations performed by the plurality of circuits for each of the changed frequencies. The processor is configured to identify a frequency that causes a malfunction of each of the plurality of circuits by matching each of the hit rates with at least one among the hit rates based on identifying completion of the booting up.

The apparatus described above may be implemented as a combination of hardware components, software components, and/or hardware components and software components. For example, the devices and components described in the embodiments may be implemented using one or more general purpose computers or special purpose computers such as processors, controllers, arithmetical logic unit (ALU), digital signal processor, microcomputers, field programmable gate array (FPGA), PLU (programmable logic unit), microprocessor, any other device capable of executing and responding to instructions. The processing device may perform an operating system OS and one or more software applications performed on the operating system. In addition, the processing device may access, store, manipulate, process, and generate data in response to execution of the software. For convenience of understanding, although one processing device may be described as being used, a person skilled in the art may see that the processing device may include a plurality of processing elements and/or a plurality of types of processing elements. For example, the processing device may include a plurality of processors or one processor and one controller. In addition, other processing configurations, such as a parallel processor, are also possible.

The software may include a computer program, code, instruction, or a combination of one or more of them and configure the processing device to operate as desired or command the processing device independently or in combination. Software and/or data may be embodied in any type of machine, component, physical device, computer storage medium, or device to be interpreted by a processing device or to provide instructions or data to the processing device. The software may be distributed on a networked computer system and stored or executed in a distributed manner. Software and data may be stored in one or more computer-readable recording media.

The method according to the embodiment may be implemented in the form of program instructions that may be performed through various computer means and recorded in a computer-readable medium. In this case, the medium may continuously store a computer-executable program or temporarily store the program for execution or download. In addition, the medium may be a variety of recording means or storage means in which a single or several hardware are combined and is not limited to media directly connected to any computer system and may be distributed on the network. Examples of media may include magnetic media such as hard disks, floppy disks and magnetic tapes, optical recording media such as CD-ROMs and DVDs, magnetooptical media such as floppy disks, ROMs, RAMs, flash memories, and the like to store program instructions. Examples of other media include app stores that distribute applications, sites that supply or distribute various software, and recording media or storage media managed by servers.

Although embodiments have been described according to limited embodiments and drawings as above, various modifications and modifications are possible from the above description to those of ordinary skill in the art. For example, even if the described techniques are performed in a different order from the described method, and/or components such as the described system, structure, device, circuit, etc. are combined or combined in a different form from the described method or are substituted or substituted by other components or equivalents, appropriate results may be achieved.

## Claims

1. An electronic device (101), comprising:
a power management integrated circuit, PMIC, (210);
a memory (130);
a processor (120);
wherein the processor is configured to:
identify whether to obtain driving information based on frequency of the processor, in response to an input indicating booting up the processor;
change frequencies (421; 422) of each of a plurality of circuits (125) in the processor by using a designated data set including information indicating a change of a frequency according to a period for controlling each of the plurality of circuits, based on the booting up, by controlling the PMIC, in a designated state for obtaining driving information based on frequency of the processor; and
obtain the driving information on the plurality of circuits in the processor corresponding to the changed frequencies, based on hit rates indicating number of operations performed by the plurality of circuits for each of the changed frequencies.

2. The electronic device of claim 1,
wherein the designated state is a first state,
wherein the processor is configured to:
identify a threshold, based on completion of the booting up the processor, and
match the hit rate with the threshold, in a second state for performing other function distinct from a function for obtaining the driving information, and
identify a frequency causing a malfunction of the other function among the frequencies, by using the hit rate.

3. The electronic device of claim 2;
wherein the processor is configured to:
store the driving information, in the memory, and
identify the threshold as a value corresponding to at least one among the hit rates, based on the driving information.

4. The electronic device of any of the preceding claims,
wherein the data set further includes information about scheduling of frequencies for driving each of the plurality of circuits.

5. The electronic device of any of the preceding claims,
wherein the processor is configured to:
identify frequencies of the plurality of circuits receiving a power signal provided from the PMIC,
identify a first circuit (120-1) operating based on a first frequency corresponding to voltage of the power signal among the plurality of circuits;
identify a second frequency of a second circuit (120-2) different from the first circuit, among the plurality of circuits;
reduce the first frequency of the first circuit, based on identifying that the voltage of the power signal exceeds voltage corresponding to the second frequency, and
change the voltage of the power signal, based on the reduced first frequency.

6. The electronic device of claim 5,
wherein the processor is configured to:
obtain a relationship between the voltage of the power signal and the second frequency of the second circuit, after the voltage of the power signal is changed by the reduced first frequency.

7. The electronic device of any of claims 5 and 6,
wherein the power signal is a first power signal,
wherein the processor is configured to:
transmit a second power signal different from the first power signal to a third circuit (311) among the plurality of circuits, from a second power source (210-2) different from a first power source (210-1) transmitting the first power signal to the first circuit and the second circuit, wherein the first power source and the second power source are included in the PMIC,
drive the third circuit, based on a third frequency corresponding to the second power signal, and
reduce the third frequency based on reducing the first frequency.

8. The electronic device of any of claims 5 - 7, wherein the processor is configured to:
obtain data indicating an interaction between a frequency for driving the first circuit and a frequency for driving the second circuit, and
identify a delay in the power signal, based on the data indicating the interaction.

9. The electronic device of claim 8,
wherein the data indicating the interaction includes information indicating difference between the first frequency and the second frequency.

10. The electronic device of any of claims 8 and 9,
wherein the processor is configured to:
obtain the data indicating the interaction, based on changing at least one frequency of the first frequency and the second frequency.

11. A computer readable storage medium storing one or more programs, wherein the one or more programs are, when executed by a processor(120) of an electronic device(101), configured to:
identify whether to obtain driving information based on frequency of a processor, in response to an input indicating booting up the processor;
change frequencies (421; 422) of each of a plurality of circuits(125) in the processor by using a designated data set including information indicating a change of a frequency according to a period for controlling each of the plurality of circuits, based on the booting up, by controlling a power management integrated circuit(PMIC) (210), in a designated state for obtaining driving information based on frequency of the processor; and
obtain the driving information on the plurality of circuits in the processor corresponding to the changed frequencies, based on hit rate indicating number of operations performed by the plurality of circuits for each of the changed frequencies.

12. The computer readable storage medium of claim 11,
wherein the designated state is a first state,
wherein the one or more programs are, when executed by the processor of the electronic device, configured to:
identify a threshold, based on completion of the booting up the processor,
match the hit rate with the threshold, in a second state for performing other function distinct from a function for obtaining the driving information, and
identify a frequency causing a malfunction of the other function among the frequencies, by using the hit rate.

13. The computer readable storage medium of claim 12,
wherein the one or more programs are, when executed by the processor of the electronic device, configured to:
store the driving information, in the memory, and
identify the threshold as a value corresponding to at least one among the hit rates, based on the driving information.

14. The computer readable storage medium of any of claims 11 - 13,
wherein the one or more programs are, when executed by the processor of the electronic device, configured to:
identify frequencies of the plurality of circuits receiving a power signal provided from the PMIC,
identify a first circuit (120-1) operating based on a first frequency corresponding to voltage of the power signal among the plurality of circuits;
identify a second frequency of a second circuit (120-2) different from the first circuit, among the plurality of circuits;
reduce the first frequency of the first circuit, based on identifying that the voltage of the power signal exceeds voltage corresponding to the second frequency, and
change the voltage of the power signal, based on the reduced first frequency.

15. The computer readable storage medium of claim 14, wherein the one or more programs are, when executed by the processor of the electronic device, configured to:
obtain a relationship between the voltage of the power signal and the second frequency of the second circuit, after the voltage of the power signal is changed by the reduced first frequency.

## Patentansprüche

1. Elektronische Vorrichtung (101), die Folgendes umfasst:
einen integrierten Schaltkreis zur Energieverwaltung, PMIC, (210);
einen Speicher (130);
einen Prozessor (120);
wobei der Prozessor zu Folgendem konfiguriert ist:
Identifizieren, ob Ansteuerungsinformationen basierend auf der Frequenz des Prozessors erhalten werden sollen, als Reaktion auf eine Eingabe, die das Hochfahren des Prozessors anzeigt;
Ändern von Frequenzen (421; 422) jedes einer Vielzahl von Schaltkreisen (125) in dem Prozessor durch Verwenden eines festgelegten Datensatzes, der Informationen enthält, die eine Änderung einer Frequenz entsprechend einem Zeitraum zum Steuern jedes der Vielzahl von Schaltkreisen anzeigen, basierend auf dem Hochfahren, durch Steuern des PMIC in einem festgelegten Zustand zum Erhalten von Ansteuerungsinformationen basierend auf der Frequenz des Prozessors; und
Erhalten der Ansteuerungsinformationen über die Vielzahl von Schaltkreisen in dem Prozessor, die den geänderten Frequenzen entsprechen, basierend auf Trefferquoten, die die Anzahl der von der Vielzahl von Schaltkreisen für jede der geänderten Frequenzen ausgeführten Vorgänge anzeigen.

2. Elektronische Vorrichtung nach Anspruch 1,
wobei der festgelegte Zustand ein erster Zustand ist,
wobei der Prozessor zu Folgendem konfiguriert ist:
Identifizieren einer Schwelle basierend auf dem Abschluss des Hochfahrens des Prozessors, und
Anpassen der Trefferquote an die Schwelle in einem zweiten Zustand zum Ausführen einer anderen Funktion, die sich von einer Funktion zum Erhalten der Ansteuerungsinformationen unterscheidet, und
Identifizieren einer Frequenz, die eine Fehlfunktion der anderen Funktion verursacht, unter den Frequenzen durch Verwenden der Trefferquote.

3. Elektronische Vorrichtung nach Anspruch 2;
wobei der Prozessor zu Folgendem konfiguriert ist:
Speichern der Ansteuerungsinformationen in dem Speicher, und
Identifizieren der Schwelle als einen Wert, der mindestens einer unter den Trefferquoten entspricht, basierend auf den Ansteuerungsinformationen.

4. Elektronische Vorrichtung nach einem der vorhergehenden Ansprüche,
wobei der Datensatz ferner Informationen über die Frequenzplanung zum Ansteuern jedes der Vielzahl von Schaltkreisen enthält.

5. Elektronische Vorrichtung nach einem der vorhergehenden Ansprüche,
wobei der Prozessor zu Folgendem konfiguriert ist:
Identifizieren von Frequenzen der Vielzahl von Schaltkreisen, die ein von dem PMIC bereitgestelltes Leistungssignal empfangen,
Identifizieren eines ersten Schaltkreises (120-1), der basierend auf einer ersten Frequenz arbeitet, die der Spannung des Leistungssignals entspricht, unter der Vielzahl von Schaltkreisen;
Identifizieren einer zweiten Frequenz eines zweiten Schaltkreises (120-2), der sich von dem ersten Schaltkreis unterscheidet, unter der Vielzahl von Schaltkreisen;
Reduzieren der ersten Frequenz des ersten Schaltkreises basierend auf dem Identifizieren, dass die Spannung des Leistungssignals die der zweiten Frequenz entsprechende Spannung überschreitet, und
Ändern der Spannung des Leistungssignals basierend auf der reduzierten ersten Frequenz.

6. Elektronische Vorrichtung nach Anspruch 5,
wobei der Prozessor zu Folgendem konfiguriert ist:
Erhalten eines Verhältnisses zwischen der Spannung des Leistungssignals und der zweiten Frequenz des zweiten Schaltkreises, nachdem die Spannung des Leistungssignals um die reduzierte erste Frequenz geändert wurde.

7. Elektronische Vorrichtung nach einem der Ansprüche 5 und 6,
wobei das Leistungssignal ein erstes Leistungssignal ist,
wobei der Prozessor zu Folgendem konfiguriert ist:
Übertragen eines zweiten Leistungssignals, das sich von dem ersten Leistungssignal unterscheidet, an einen dritten Schaltkreis (311) unter der Vielzahl von Schaltkreisen, von einer zweiten Leistungsquelle (210-2), die sich von der ersten Leistungsquelle (210-1) unterscheidet, die das erste Leistungssignal an den ersten Schaltkreis und den zweiten Schaltkreis überträgt, wobei die erste Leistungsquelle und die zweite Leistungsquelle in dem PMIC enthalten sind,
Ansteuern des dritten Schaltkreises basierend auf einer dritten Frequenz, die dem zweiten Leistungssignal entspricht, und
Reduzieren der dritten Frequenz basierend auf dem Reduzieren der ersten Frequenz.

8. Elektronische Vorrichtung nach einem der Ansprüche 5 - 7, wobei der Prozessor zu Folgendem konfiguriert ist:
Erhalten von Daten, die eine Wechselwirkung zwischen einer Frequenz zum Ansteuern des ersten Schaltkreises und einer Frequenz zum Ansteuern des zweiten Schaltkreises anzeigen, und
Identifizieren einer Verzögerung in dem Leistungssignal basierend auf den Daten, die die Wechselwirkung anzeigen.

9. Elektronische Vorrichtung nach Anspruch 8,
wobei die Daten, die die Wechselwirkung anzeigen, Informationen enthalten, die den Unterschied zwischen der ersten Frequenz und der zweiten Frequenz anzeigen.

10. Elektronische Vorrichtung nach einem der Ansprüche 8 und 9,
wobei der Prozessor zu Folgendem konfiguriert ist:
Erhalten der Daten, die die Wechselwirkung anzeigen, basierend auf dem Ändern mindestens einer Frequenz der ersten Frequenz und der zweiten Frequenz.

11. Computerlesbares Speichermedium, das ein oder mehrere Programme speichert, wobei das eine oder die mehreren Programme, wenn sie von einem Prozessor (120) einer elektronischen Vorrichtung (101) ausgeführt werden, zu Folgendem konfiguriert sind:
Identifizieren, ob Ansteuerungsinformationen basierend auf der Frequenz eines Prozessors erhalten werden sollen, als Reaktion auf eine Eingabe, die das Hochfahren des Prozessors anzeigt;
Ändern von Frequenzen (421; 422) jedes einer Vielzahl von Schaltkreisen (125) in dem Prozessor durch Verwenden eines festgelegten Datensatzes, der Informationen enthält, die eine Änderung einer Frequenz entsprechend einem Zeitraum zum Steuern jedes der Vielzahl von Schaltkreisen anzeigen, basierend auf dem Hochfahren, durch Steuern eines integrierten Schaltkreises zur Energieverwaltung (PMIC) (210) in einem festgelegten Zustand zum Erhalten von Ansteuerungsinformationen basierend auf der Frequenz des Prozessors; und
Erhalten der Ansteuerungsinformationen über die Vielzahl von Schaltkreisen in dem Prozessor, die den geänderten Frequenzen entsprechen, basierend auf der Trefferquote, die die Anzahl der von der Vielzahl von Schaltkreisen für jede der geänderten Frequenzen ausgeführten Vorgänge anzeigt.

12. Computerlesbares Speichermedium nach Anspruch 11,
wobei der festgelegte Zustand ein erster Zustand ist,
wobei das eine oder die mehreren Programme, wenn sie von dem Prozessor der elektronischen Vorrichtung ausgeführt werden, zu Folgendem konfiguriert sind:
Identifizieren einer Schwelle basierend auf dem Abschluss des Hochfahrens des Prozessors,
Anpassen der Trefferquote an die Schwelle in einem zweiten Zustand zum Ausführen einer anderen Funktion, die sich von einer Funktion zum Erhalten der Ansteuerungsinformationen unterscheidet, und
Identifizieren einer Frequenz, die eine Fehlfunktion der anderen Funktion verursacht, unter den Frequenzen durch Verwenden der Trefferquote.

13. Computerlesbares Speichermedium nach Anspruch 12,
wobei das eine oder die mehreren Programme, wenn sie von dem Prozessor der elektronischen Vorrichtung ausgeführt werden, zu Folgendem konfiguriert sind:
Speichern der Ansteuerungsinformationen in dem Speicher, und
Identifizieren der Schwelle als einen Wert, der mindestens einer unter den Treffquoten entspricht, basierend auf den Ansteuerungsinformationen.

14. Computerlesbares Speichermedium nach einem der Ansprüche 11 - 13,
wobei das eine oder die mehreren Programme, wenn sie von dem Prozessor der elektronischen Vorrichtung ausgeführt werden, zu Folgendem konfiguriert sind:
Identifizieren von Frequenzen der Vielzahl von Schaltkreisen, die ein von dem PMIC bereitgestelltes Leistungssignal empfangen,
Identifizieren eines ersten Schaltkreises (120-1), der basierend auf einer ersten Frequenz arbeitet, die der Spannung des Leistungssignals entspricht, unter der Vielzahl von Schaltkreisen;
Identifizieren einer zweiten Frequenz eines zweiten Schaltkreises (120-2), der sich von dem ersten Schaltkreis unterscheidet, unter der Vielzahl von Schaltkreisen;
Reduzieren der ersten Frequenz des ersten Schaltkreises basierend auf dem Identifizieren, dass die Spannung des Leistungssignals die Spannung überschreitet, die der zweiten Frequenz entspricht, und
Ändern der Spannung des Leistungssignals basierend auf der reduzierten ersten Frequenz.

15. Computerlesbares Speichermedium nach Anspruch 14, wobei das eine oder die mehreren Programme, wenn sie von dem Prozessor der elektronischen Vorrichtung ausgeführt werden, zu Folgendem konfiguriert sind:
Erhalten eines Verhältnisses zwischen der Spannung des Leistungssignals und der zweiten Frequenz des zweiten Schaltkreises, nachdem die Spannung des Leistungssignals um die reduzierte erste Frequenz geändert wurde.

## Revendications

1. Dispositif électronique (101), comprenant :
un circuit intégré de gestion d'énergie, PMIC, (210) ;
une mémoire (130) ;
un processeur (120) ;
où le processeur est configuré pour :
identifier s'il convient obtenir des informations de pilotage sur la base de la fréquence du processeur, en réponse à une entrée indiquant le démarrage du processeur ;
modifier les fréquences (421 ; 422) de chacun d'une pluralité de circuits (125) dans le processeur en utilisant un ensemble de données désigné incluant des informations indiquant une modification d'une fréquence selon une période pour contrôler chacun de la pluralité de circuits, sur la base du démarrage, en contrôlant le PMIC, dans un état désigné pour obtenir des informations de pilotage sur la base de la fréquence du processeur ; et
obtenir les informations de pilotage sur la pluralité de circuits dans le processeur correspondant aux fréquences modifiées, sur la base de taux de succès indiquant le nombre d'opérations effectuées par la pluralité de circuits pour chacune des fréquences modifiées.

2. Dispositif électronique selon la revendication 1,
où l'état désigné est un premier état,
où le processeur est configuré pour :
identifier un seuil, sur la base de l'achèvement du démarrage du processeur, et
faire correspondre le taux de succès avec le seuil, dans un deuxième état pour effectuer une autre fonction distincte d'une fonction pour obtenir les informations de pilotage, et
identifier une fréquence provoquant un dysfonctionnement de l'autre fonction parmi les fréquences, en utilisant le taux de succès.

3. Dispositif électronique selon la revendication 2 ;
où le processeur est configuré pour :
stocker les informations de pilotage, dans la mémoire, et
identifier le seuil comme une valeur correspondant à au moins l'un parmi les taux de succès, sur la base des informations de pilotage.

4. Dispositif électronique selon l'une quelconque des revendications précédentes,
où l'ensemble de données inclut en outre des informations sur l'ordonnancement de fréquences pour piloter chacun de la pluralité de circuits.

5. Dispositif électronique selon l'une quelconque des revendications précédentes,
où le processeur est configuré pour :
identifier les fréquences de la pluralité de circuits recevant un signal d'énergie fourni par le PMIC,
identifier un premier circuit (120-1) fonctionnant sur la base d'une première fréquence correspondant à la tension du signal d'énergie parmi la pluralité de circuits ;
identifier une deuxième fréquence d'un deuxième circuit (120-2) différent du premier circuit, parmi la pluralité de circuits ;
réduire la première fréquence du premier circuit, sur la base de l'identification du fait que la tension du signal d'énergie dépasse la tension correspondant à la deuxième fréquence, et
modifier la tension du signal d'énergie, sur la base de la première fréquence réduite.

6. Dispositif électronique selon la revendication 5,
où le processeur est configuré pour :
obtenir une relation entre la tension du signal d'énergie et la deuxième fréquence du deuxième circuit, après que la tension du signal d'énergie a été modifiée par la première fréquence réduite.

7. Dispositif électronique selon l'une quelconque des revendications 5 et 6,
où le signal d'énergie est un premier signal d'énergie,
où le processeur est configuré pour :
transmettre un deuxième signal d'énergie différent du premier signal d'énergie à un troisième circuit (311) parmi la pluralité de circuits, à partir d'une deuxième source d'énergie (210-2) différente d'une première source d'énergie (210-1) qui transmet le premier signal d'énergie au premier circuit et au deuxième circuit, où la première source d'énergie et la deuxième source d'énergie sont incluses dans le PMIC,
piloter le troisième circuit, sur la base d'une troisième fréquence correspondant au deuxième signal d'énergie, et
réduire la troisième fréquence sur la base de la réduction de la première fréquence.

8. Dispositif électronique selon l'une quelconque des revendications 5 à 7, où le processeur est configuré pour :
obtenir des données indiquant une interaction entre une fréquence pour piloter le premier circuit et une fréquence pour piloter le deuxième circuit, et
identifier un retard dans le signal d'énergie, sur la base des données indiquant l'interaction.

9. Dispositif électronique selon la revendication 8,
où les données indiquant l'interaction incluent des informations indiquant la différence entre la première fréquence et la deuxième fréquence.

10. Dispositif électronique selon l'une quelconque des revendications 8 et 9,
où le processeur est configuré pour :
obtenir les données indiquant l'interaction, sur la base de la modification d'au moins une fréquence parmi la première fréquence et la deuxième fréquence.

11. Support de stockage lisible par ordinateur stockant un ou plusieurs programmes, où l'un ou plusieurs programmes, lorsqu'ils sont exécutés par un processeur (120) d'un dispositif électronique (101), sont configurés pour :
identifier s'il faut obtenir des informations de pilotage sur la base de la fréquence d'un processeur, en réponse à une entrée indiquant le démarrage du processeur ;
modifier les fréquences (421 ; 422) de chacun d'une pluralité de circuits (125) dans le processeur en utilisant un ensemble de données désigné incluant des informations indiquant une modification d'une fréquence selon une période pour commander chacun de la pluralité de circuits, sur la base du démarrage, en commandant un circuit intégré de gestion d'énergie (PMIC) (210), dans un état désigné pour obtenir des informations de pilotage sur la base de la fréquence du processeur ; et
obtenir les informations de pilotage sur la pluralité de circuits dans le processeur correspondant aux fréquences modifiées, sur la base d'un taux de succès qui indique le nombre d'opérations effectuées par la pluralité de circuits pour chacune des fréquences modifiées.

12. Support de stockage lisible par ordinateur selon la revendication 11,
où l'état désigné est un premier état,
où l'un ou plusieurs programmes, lorsqu'ils sont exécutés par le processeur du dispositif électronique, sont configurés pour :
identifier un seuil, sur la base de l'achèvement du démarrage du processeur,
faire correspondre le taux de succès avec le seuil, dans un deuxième état pour effectuer une autre fonction distincte d'une fonction pour obtenir les informations de pilotage, et
identifier une fréquence provoquant un dysfonctionnement de l'autre fonction parmi les fréquences, en utilisant le taux de succès.

13. Support de stockage lisible par ordinateur selon la revendication 12,
où l'un ou plusieurs programmes, lorsqu'ils sont exécutés par le processeur du dispositif électronique, sont configurés pour :
stocker les informations de pilotage, dans la mémoire, et
identifier le seuil comme une valeur correspondant à au moins l'un parmi les taux de succès, sur la base des informations de pilotage.

14. Support de stockage lisible par ordinateur selon l'une quelconque des revendications 11 à 13,
où l'un ou plusieurs programmes, lorsqu'ils sont exécutés par le processeur du dispositif électronique, sont configurés pour :
identifier les fréquences de la pluralité de circuits recevant un signal d'énergie fourni par le PMIC,
identifier un premier circuit (120-1) fonctionnant sur la base d'une première fréquence correspondant à la tension du signal d'énergie parmi la pluralité de circuits ;
identifier une deuxième fréquence d'un deuxième circuit (120-2) différent du premier circuit, parmi la pluralité de circuits ;
réduire la première fréquence du premier circuit, sur la base de l'identification du fait que la tension du signal d'énergie dépasse la tension correspondant à la deuxième fréquence, et
modifier la tension du signal d'énergie, sur la base de la première fréquence réduite.

15. Support de stockage lisible par ordinateur selon la revendication 14, où l'un ou plusieurs programmes, lorsqu'ils sont exécutés par le processeur du dispositif électronique, sont configurés pour :
obtenir une relation entre la tension du signal d'énergie et la deuxième fréquence du deuxième circuit, après que la tension du signal d'énergie a été modifiée par la première fréquence réduite.
